# EUROPEAN PATENT APPLICATION

(11) **EP 1 959 262 A1**
(43) Date of publication of application: **20.08.2008**
(21) Application number: 07102650.4
(22) Date of filing: 19.02.2007
(51) Int. Cl.: G01R 3/00, G01R 31/28

(54) **Test of electronic devices using boards without sockets**

(71) Applicant: Eles Semiconductor Equipment S.P.A., 06059 Todi (Perugia) (IT)
(72) Inventor: Scocchetti, Fabrizio c/o ELES Semiconductor Equipment S.p.A., I-06059, TODI (PG) (IT)
(74) Representative: Pezzoli, Ennio

(57) **Abstract**

A test equipment (100) is proposed. The test equipment is used to test a set of electronic devices (105,105'), each one having a plurality of terminals (210,210'). The test equipment includes: contact means (125,125') for contacting the terminals of the electronic devices electrically, locking means (130) for locking the electronic devices with the contact means mechanically, and conditioning means (130) for conditioning the electronic devices thermally; the locking means and the conditioning means include pressing means (130) for acting on the electronic devices, the pressing means being adapted to push the electronic devices towards the contact means and to warm or cool the electronic devices.

## Description

### Technical field

The present invention relates to the test field. More specifically, the present invention relates to the test of electronic devices.

### Background

Electronic devices (typically including one or more integrated circuits) are generally subjected to a test process in order to verify their correct operation; this is of the utmost importance to ensure a high quality of the manufacturing cycle of the electronic devices. The test can be aimed at identifying defects that are either evident or potential (i.e., which might occur after a short period of use). At the same time, the integrated circuits under test may be conditioned thermally (so as to ensure that they work at a predetermined temperature). A typical example is the burn-in test, which consists of making the electronic devices work for some hours at very high or very low temperature, in order to simulate a long period of operation of the same electronic devices at room temperature.

The test may be performed either at the wafer level or at the package level. In the first case, the integrated circuits are tested directly - when they are still included in a wafer of semiconductor material; conversely, in the second case the electronic devices are tested once their manufacture is complete (i.e., the integrated circuits have been diced and embedded in suitable packages). The test at the package level reduces the risks of damages to the integrated circuits (for example, due to atmospheric contaminations or shocks); moreover, it allows testing the electronic devices in their actual final form.

For this purpose, the electronic devices are mounted on test boards, which are used to interface the electronic devices with a test equipment. Each test board is provided with multiple sockets; the sockets lock the electronic devices mechanically and connect them electrically to the test equipment. Once the test boards have been inserted into the test equipment, the corresponding electronic devices are conditioned thermally; typically, this result is achieved by forcing hot or cold air towards the test boards. Stimulus signals are then applied to the electronic devices, and corresponding response signals are recorded. At the end of the test process, the test boards are extracted from the test equipment. The electronic devices can now be removed from the test boards (thanks to the sockets that allow mounting the electronic devices on the test boards with the possibility of disengaging them with limited damages).

However, the proposed solution is not completely satisfactory. Indeed, the structure of the sockets is relatively complex. Moreover, their assembling on the test boards requires a number of operations; for example, the sockets are soldered on the test boards or they are snap mounted thereon. In any case, this adversely affects the cost of the test boards, and then of the operation of the test equipments.

Moreover, the conditioning systems based on the hot/cold air are very bulky; this has a detrimental impact on the size of the test equipments and on their cost.

Anyway, the control of the temperature of the electronic devices so obtained is not completely effective. Particularly, it is very difficult (if not impossible) to obtain a uniform distribution of the temperature throughout the different electronic devices under test.

At the end, the test processes known in the art require that the electronic devices should be mounted on the test boards in a dedicated assembling station. The test boards are then moved to the test equipment for testing the (carried) electronic devices. At the end of the test process, the test boards are returned to the assembling station for removing the (tested) electronic devices. It is now possible to insert the electronic devices that passed the test into trays that will be used for their final packaging and shipping. However, the above-described operations (and especially the need of assembling/disassembling the test boards and moving them to and from the test equipment) add further complexity and increase the length of the test process.

All of the above maintains the overall cost of the test process relatively high; this drawback limits the use of the test process, and accordingly lowers the level of quality and reliability in the production of the electronic devices.

### Summary

In its general terms, the present invention is based or on the idea of using a pushing action to both lock and condition the electronic devices.

Particularly, the present invention provides a solution as set out in the independent claims. Advantageous embodiments of the invention are described in the dependent claims.

More specifically, an aspect of the invention provides a test equipment for testing a set of electronic devices; each electronic device has a plurality of terminals. The test equipment includes contact means for contacting the terminals of the electronic devices electrically. Locking means is provided for locking the electronic devices with the contact means mechanically; moreover, conditioning means is provided for conditioning the electronic devices thermally. The locking means and the conditioning means include pressing means for acting on the electronic devices; the pressing means is adapted to push the electronic devices towards the contact means and to warm or cool the electronic devices.

In a preferred embodiment of the invention, this result is achieved by means of a box that defines a chamber with a variable volume (for acting on the electronic devices when expanded); the volume of the chamber is controlled by the pressure of a conditioning fluid (which also controls the temperature of the electronic devices).

Advantageously, the conditioning fluid is made to circulate through a hydraulic circuit (including a heat exchanger or an equivalent element).

A suggested implementation of the above-described box is based on a flexible membrane, which is made of a thermally conductive material.

As a further improvement, the membrane is held integral with a rigid body of the box in a plurality of internal points (within its edge).

Preferably, this result is achieved by means of a plurality of pins extending from a bottom surface of the rigid body to the membrane.

In an embodiment of the invention, the test equipment is provided with one or more test boards (with seats for resting the terminals of the electronic devices).

As a further enhancement, the seats consist of concave recesses matching the terminals.

In a different embodiment of the invention, each test board further includes means for aligning the terminals of each electronic device with the corresponding seats.

For example, this result is achieved by means of centering towers interfering with corners of a case of the electronic device.

A further aspect of the invention proposes a test board for use in the test equipment.

A still further aspect of the invention proposes a process for manufacturing this test board; the process is based on the use of a forming tool that acts as a die for pressing isles made of an electrically conductive and deformable material (for the seats).

In an advantageous embodiment, the isles are obtained by means of a silk-screen printing operation.

Furthermore, the same forming tool may also be used to print columns of a deformable material (for the centering towers).

In this case as well, the columns may be obtained by means of a further silk-screen printing operation.

Another aspect of the invention proposes a corresponding method for testing electronic devices.

### Brief description of the drawings

The invention itself, as well as further features and the advantages thereof, will be best understood with reference to the following detailed description, given purely by way of a non-restrictive indication, to be read in conjunction with the accompanying drawings. In this respect, it is expressly intended that the figures are not necessary drawn to scale and that, unless otherwise indicated, they are merely intended to conceptually illustrate the structures and procedures described herein. Particularly:
Figure 1 is a pictorial representation of a test equipment that may be used to implement the solution according to an embodiment of the invention;
Figures 2a and 2b illustrate operation of a thermal press of the test equipment according to an embodiment of the invention;
Figure 3 is an exploded view of this press according to an embodiment of the invention;
Figures 4a-4e show the various stages of a process that may be used to manufacture a test board according to an embodiment of the invention;
Figures 5a and 5b illustrate the application of the solution according to an embodiment of the invention to a different type of electronic devices; and
Figures 6a-6e show the various stages of a process that may be used to manufacture a test board according to another embodiment of the invention.

### Detailed description

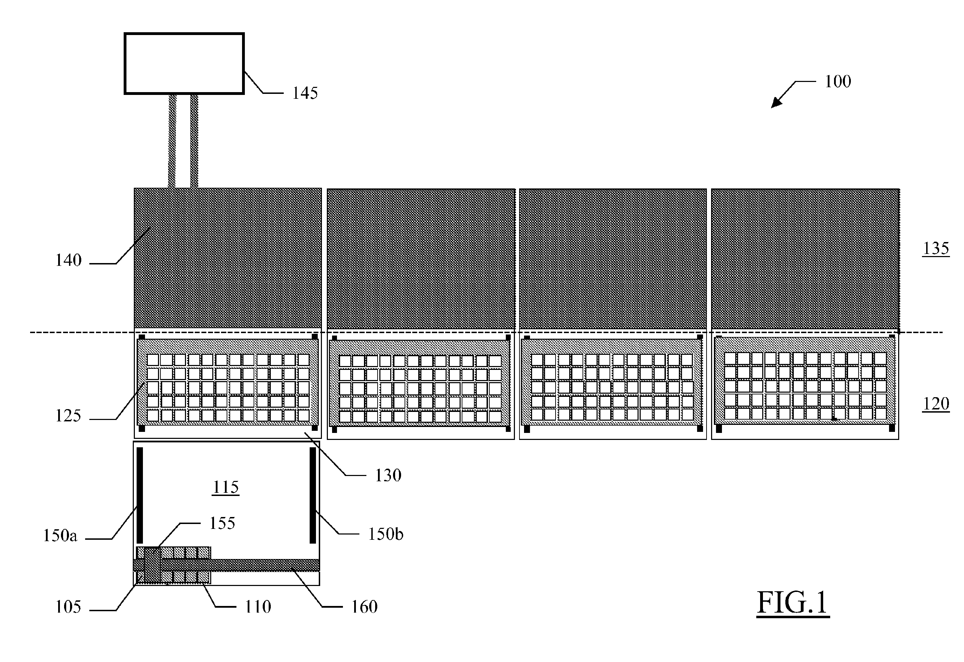

With reference in particular to Figure 1, a test equipment 100 is illustrated. The test equipment 100 is used to test electronic devices 105 at the package level (i.e., in their final form); for example, the test is of the burn-in type (wherein the electronic devices 105 are tested under thermal stress conditions). For this purpose, the electronic devices 105 are made to work for some hours at very high or very low temperature (such as ranging from -50°C to +150°C); in this way, it is possible to simulate a long period of operation of the same electronic devices 105 at room temperature (i.e., 25°C-50°C), so as to identify the electronic devices 105 that would fail during their initial life period.

The electronic devices 105 to be tested are provided in a tray 110 (that will be used for their final packaging and shipping). A loader/unloader 115 extracts the electronic devices 105 from the tray 110 and feeds them in succession to a conditioning area 120 of the test equipment 110 (which is used to control the temperature of the electronic devices 105 during the burn-in test).

For this purpose, a plurality of test boards 125 - consisting of Bum-In Boards (BIBs) in the example at issue - are arranged in the conditioning area 120. Each burn-in board 125 includes multiple housings each one for receiving an electronic device 105 to be tested (such as with a matrix of housings having 2-10 rows and 5-20 columns). Each burn-in board 125 is coupled with a corresponding thermal press 130 (arranged above it). As described in detail in the following, the electronic devices 105 are simply placed on the burn-in board 125 (without any socket); the press 130 is used to lock the electronic devices 105 mechanically on the burn-in board 125 and to condition them thermally.

The test equipment 100 is also provided with a control area 135, which is maintained at room temperature; the control area 135 is thermally insulated from the conditioning area 120, with the two areas 120 and 135 that communicate through slots provided with protective seals. Particularly, the control area 135 houses a plurality of driving boards 140. Each burn-in board 125 (when inserted in the conditioning area 120) is connected electrically to a corresponding driving board 140. The driving board 140 includes the circuitry that is used to control the burn-in test of the electronic devices 105 arranged on the burn-in board 125; particularly, the driving board 140 provides a power supply and stimulus signals to and receives corresponding result signals from the electronic devices 105. The control area 135 also includes a pneumatic system 145, which is used to control the presses 130 (as it will be apparent in the following).

In order to test a set of integrated circuits 105, the tray 105 with these electronic circuits 105 is moved to the loader/unloader 115, which is placed in front of a (current) burn-in board 125. This burn-in board 125 is extracted from the conditioning area 120; particularly, the burn-in board 125 is disengaged from the corresponding driving board 140, and it is made to slide on a pair of rails 150a and 150b of the loader/unloader 115. A head 155 of the loader/unloader 115 (for example, of the vacuum type) picks up a (current) electronic device 105 from the tray 110. The head 155 is mounted on a bar 160, which slides toward the burn-in board 125 until reaching the row of a target housing (for the electronic device 105). The head 155 in turn slides along the bar 160 until reaching the column of the target housing. At this point, the head 155 releases the electronic device 105 onto the target housing. The same operations described above are repeated until the burn-in board 125 has been filled up. The burn-in board 105 in then inserted into the conditioning area 120, with the mounted electronic devices 105, so as to return to its original position (coupled with the corresponding driving board 140). The loader/unloader 115 is moved in front of a next burn-in board 125, so as to reiterate the same operations (until all the desired electronic devices 105 have been loaded into the test equipment 100).

At the end of the test process, the operations described above are repeated in reverse order. Particularly, a (current) burn-in board 125 is extracted from the conditioning area 120 by sliding on the rails 150a and 150b of the loader/unloader 115 (placed in front of it). The head 155 is moved over each electronic device 105 being placed on the burn-in board 125 (by sliding the bar 160 to its row and then sliding the head 155 along the bar 160 until reaching its column). The head 155 picks up the electronic device 105 and returns to a free location of the tray 110. At this point, the head 155 releases the electronic device 105 onto the tray 110. The same operations described above are repeated until the burn-in board 125 has been emptied. The burn-in board 105 in then returned to the conditioning area 120. The loader/unloader 115 is moved in front of a next burn-in board 125, so as to reiterate the same operations (until all the tested electronic devices 105 have been returned to the tray 110).

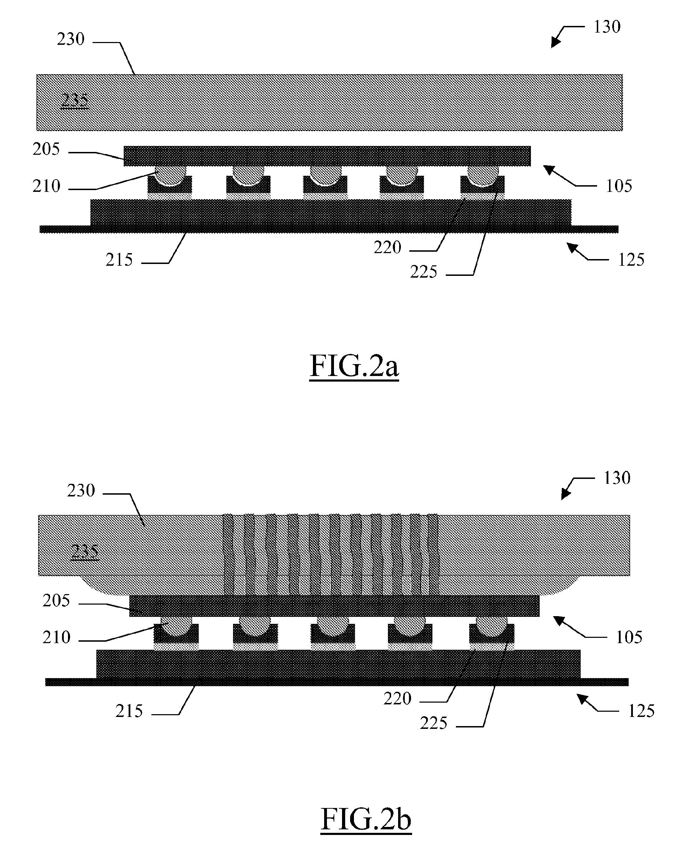

Moving now to Figure 2a, a generic electronic device 105 under test includes an integrated circuit being formed in a chip of semiconductor material (not shown in the figure); the chip is embedded in a case 205, which consists of an insulating body protecting the chip from damages. The chip is connected electrically to external terminals 210 of the electronic device 105, which implement any Input/Output (I/O) function of the integrated circuit. In the example at issue, the electronic device 105 is of the Ball Grid Array (BGA) type, wherein the terminals 210 consist of a matrix of small balls arranged on a (lower) front surface of the case 205.

On the other hand, the burn-in board 125 is formed by a circuitized insulating substrate 215 (for example, consisting of a printed circuit board with one or more layers of conductive tracks). A top surface of the substrate 215 is provided with a matrix of conductive pads 220 for contacting the terminals 210 electrically (which pads 220 are in turn connected electrically to the tracks of the substrate 215 to route the desired signals). A conductive seat 225 is formed on top of each pad 220 for receiving the corresponding terminal 210.

As described in detail in the following, in the solution according to an embodiment of the present invention the press 130 includes a box 230. The box 230 defines a chamber 235, which has a variable volume; moreover, the box 230 can apply or absorb heat (for example, by means of a conditioning fluid flowing through it).

In this way, as shown in Figure 2b, when the chamber 235 expands the box 230 acts on an (upper) back surface of the case 205 - without any terminals 210. The box 230 then pushes the terminals 210 into the corresponding seats 225. Therefore, the electronic device 105 is locked mechanically with the burn-in board 125; moreover, this ensures the correct electrical contact between the terminals 210 and the seats 225. At the same time, the box 230 warms or cools the electronic device 105, so as to maintain it at the desired temperature during the burn-in test.

Conversely, when the chamber 235 reduces (returning to the condition shown in Figure 2a) the box 230 does not interfere with the back surface of the case 205 any longer. Therefore, the electronic device 105 is released. This allows removing the electronic device 105 from the burn-in board 125 at the end of the test process without any damage.

The proposed solution strongly simplifies the structure of the burn-in boards (or more generally of any test boards), since they do not have any sockets for locking the electronic devices; therefore, it is possible to reduce the number of operations required for manufacturing the test boards (without the ones needed for assembling the sockets). This has a beneficial effect on the cost of the test boards, and then of the operation of the test equipment.

Moreover, the proposed solution allows removing the (bulky) conditioning systems based on the hot/cold air from the test equipment; as a result, the size of the test equipment - and then its cost as well - is reduced.

Anyway, the devised technique for conditioning the electronic devices thermally is very effective. Particularly, the direct action of the press on the cases allows obtaining a substantially uniform distribution of the temperature throughout the different electronic devices under test.

At the end, as pointed out above, during the test process the electronic devices can be moved only by means of the trays that will be used for their final packaging (with the loader/unloader that is integrated in the test equipment, without the need of any external assembling station for the test boards). This further simplifies and shortens the test process.

All of the above contributes to reduce the overall cost of the burn-in test (or more generally of any test process); this fosters the widespread diffusion of the test process, with a beneficial effect on the quality and reliability in the production of the electronic devices.

In the specific embodiment of the invention described above, the terminals 210 (of the electronic device 105) rest on the corresponding seats 225 (of the burn-in board 125); this facilitates their correct electrical coupling. Preferably, as shown in Figures 2a and 2b, the seats 225 have a concave shape. Therefore, it is possible to obtain a self-centering of the (rounded) terminals 210 in the seats 225 - under the pressure applied by the press 230. This facilitates the positioning of the electronic device 105 on the burn-in board 125 (by the above-described 3-axes positioning system of the test equipment); moreover, it is also possible to prevent any misalignment of the electronic device 105 with respect to the burn-in board 125 (for example, during its insertion into and extraction from the test equipment).

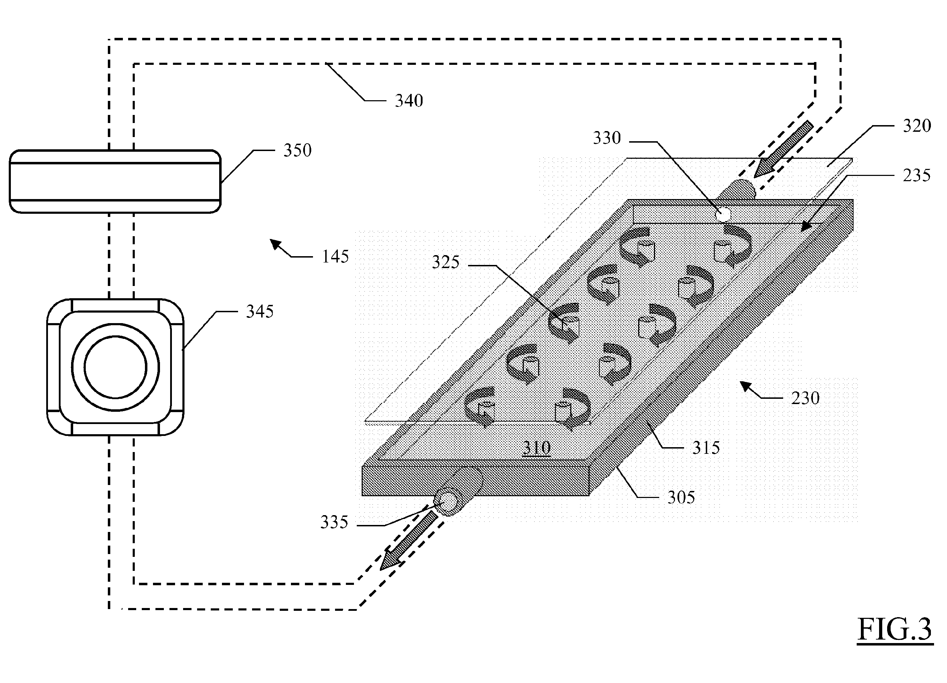

Considering now Figure 3, the structure of the box 230 (turned upside down for the sake of illustration) is described in greater detail. As mentioned above, the chamber 235 defined by the box 230 has a variable volume, which is controlled by the conditioning fluid flowing through it; at the same time, the temperature of the conditioning fluid allows applying or absorbing heat to/from the electronic devices. The conditioning fluid is selected so as to maintain its state at any working temperature of the test equipment; a suggested choice for this conditioning fluid is glycol (which supports temperatures ranging from-60°C to +300°C).

More specifically, the box 230 includes an open rigid body 305, which is shaped like a tray. Particularly, the tray 305 has a bottom surface 310 with a rectangular shape; the bottom surface 310 has a size slightly larger than the one of the corresponding burn-in board (for example, 10-30 cm x 30-50 cm). Four sidewalls 315 extend perpendicularly from an edge of the bottom surface 310 (for example, with a height of 1-3 cm). A flexible membrane 320 closes the tray 305, so as to define the chamber 235. The membrane 320 is made of an (elastic) thermally conductive material; for example, the membrane 320 consists of a sheet of silicone (with a thickness of 0.5-2 mm). The membrane 320 is fastened to the tray 305 along a free edge of the sidewalls 315. In this way, the membrane 320 can deform according to the pressure of the conditioning fluid in the chamber 235. Particularly, when the pressure in the chamber 235 increases, the membrane 320 raises so as to act on the electronic devices (pushing them against the burn-in board); conversely, when the pressure reduces, the membrane 320 goes down so as to release the electronic devices. At the same time, when the membrane 320 is in contact with the electronic devices, the conditioning fluid in the chamber 235 applies or removes heat to/from the electronic devices through the membrane 320 (so as to maintain them at the desired temperature).

The proposed structure is very simple and cost effective. Nevertheless, the flexible membrane 320 allows compensating any non-planarity of the electronic devices individually (so as to ensure the correct electrical contact with the burn-in board in any condition).

Preferably, a matrix of pins 325 projects upwards from the bottom surface 310 (being distributed uniformly inside its border); the pins 325 have the same height of the sidewalls 315 (1-3 cm in the example at issue). The membrane 320 is further fastened to the pins 325. In this way (when the pressure in the chamber 235 increases) the membrane 320 cannot raise in the points wherein the pins 325 hold it. Therefore, the membrane 325 expands approximately in the same way throughout its whole extent; this provides a more uniform distribution of the pressure that is applied to the electronic devices. It should be noted that the pins 325 allow achieving the desired result substantially without any interference with the circulation of the conditioning fluid in the chamber 235.

An inlet 330 (for the conditioning fluid) is opened in the sidewall 315 extending from one of the shorter edges of the bottom surface 310; a corresponding outlet 335 is opened in the opposed sidewall 315 (extending from the other shorter edge of the bottom surface 310). A duct 340 defines a hydraulic circuit that connects the chamber 235 (through its inlet 330 and outlet 335) to the pneumatic system 145 of the test equipment. Particularly, the pneumatic system 145 includes a pump 345, which sucks the conditioning fluid from the chamber 235 through the outlet 335. The pump 345 forces the conditioning fluid towards a heat exchanger 350. The heat exchanger 350 warms or cools the conditioning fluid according to the required temperature (for the electronic devices); the conditioning fluid is then injected into the chamber 235 with the required pressure (for the volume of the chamber 235) through the inlet 330. In this way, the conditioning fluid flows continuously through the pump 345, the heat exchanger 350 and the chamber 235; this allows applying the desired pressure and maintaining the desired temperature in a very simple and effective way.

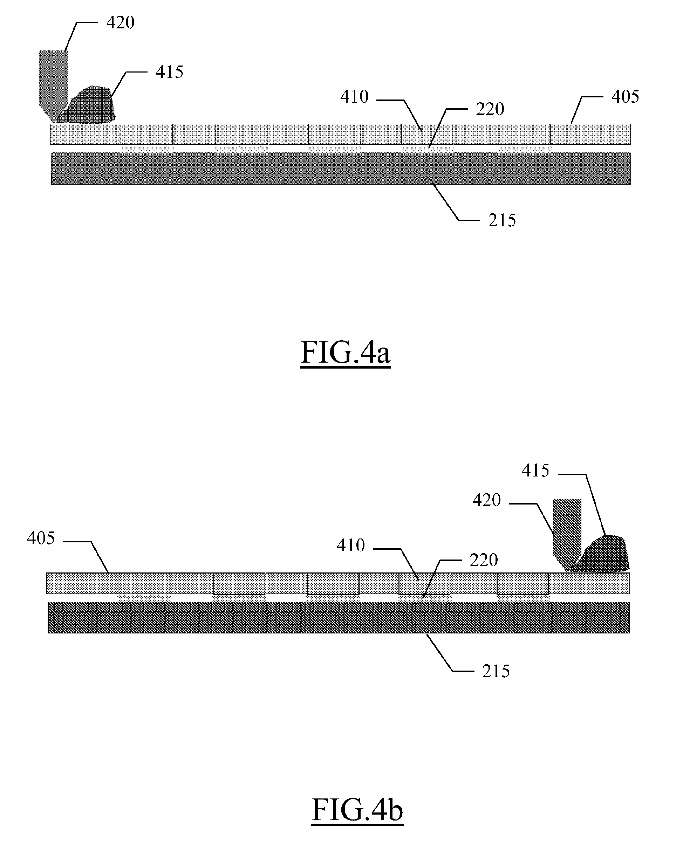

The various stages of a process that may be used to manufacture the above-described burn-in board are illustrated in Figures 4a-4e.

Considering in particular Figure 4a, the process starts with the substrate 215; the pads 220 are formed on the top surface of the substrate 215 - in the positions corresponding to the terminals of the electronic devices to be tested - by means of conventional photolithographic techniques (for example, by depositing a layer of Aluminum that is then etched selectively).

A precursor material required to create the desired seats is distributed on the pads 220 by means of a silk-screen printing operation. For this purpose, a stencil 405 is placed on the substrate 215. The stencil 405 includes a matrix of windows 410 corresponding to the pads 220. A polymer 415 is then applied on the pads 220 - through the stencil 405 - by means of a knife 420; the polymer 415 consists of a material that is electrical conductive and deformable (such as the commercial product "Loctite 3880" by Loctite Corp.).

As shown in Figure 4b, this result is achieved by making the knife 420 cross the whole stencil 405; in this way, the polymer 415 is pushed into the windows 410.

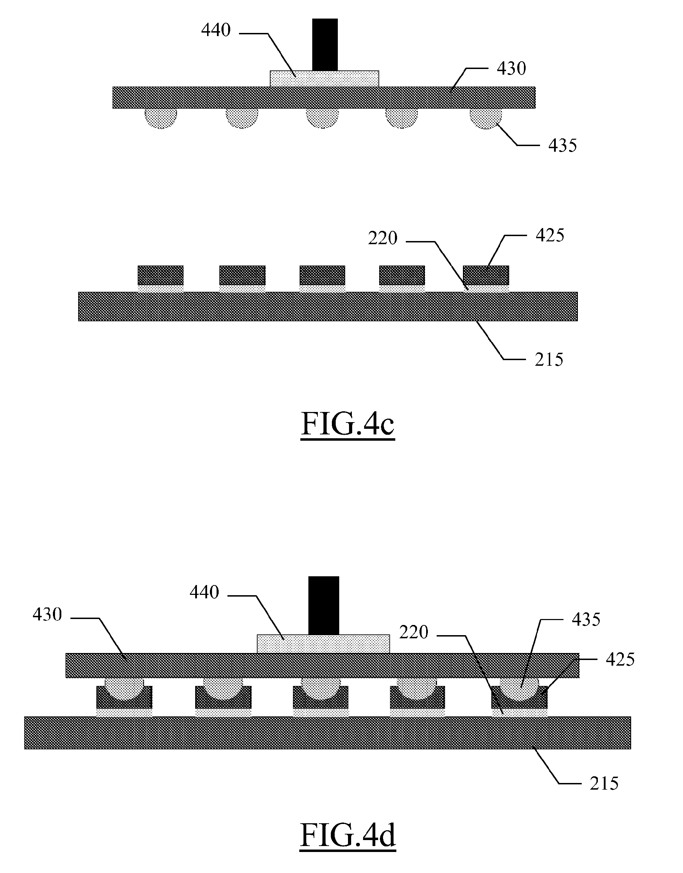

Moving to Figure 4c, when the stencil is removed an isle 425 of the polymer remains on each pad 220. The isles 425 are then shaped - according to the terminals of the electronic devices to be tested - by means of a forming tool 430. For this purpose, a bottom surface of the forming tool 430 is provided with a matrix of dummy elements 435 mimicking the terminals of the electronic devices; the forming tool 430 may consist of either a dummy component or a sample of the electronic devices. The forming tool 430 is mounted on a pick and place head 440; the head 440 is controlled by means of an optical system, such as of the laser or infrared type (not shown in the figure), which allows aligning the dummy elements 435 correctly with the isles 425.

At this point, the head 440 is lowered so as to push the forming tool 430 against the substrate 215 (see Figure 4d). Therefore, the dummy elements 435 act as a die that presses the isles 425 accordingly; the isles 425 are then shaped as a negative of the dummy elements 435 (and then of the terminals of the electronic devices).

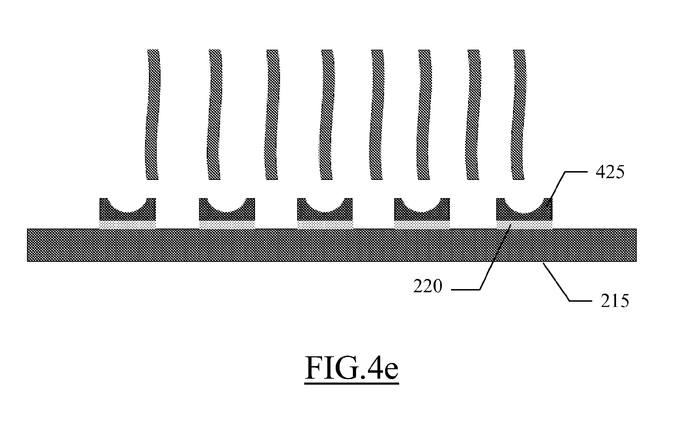

Moving to Figure 4e, the head is raised and the forming tool is removed. The structure so obtained is now passed in an oven (for example, at 125-200 °C for 10-30 min.), so as to polymerize the material forming the (shaped) isles 425. In this way, the isles 425 harden to provide the desired seats for the terminals of the electronic devices.

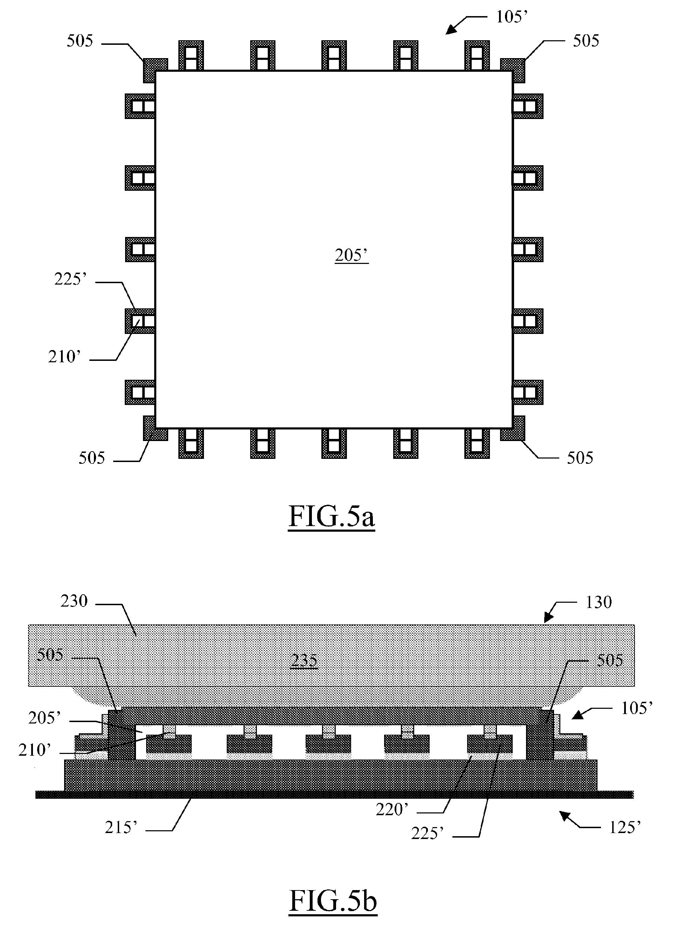

The application of the proposed solution to different electronic devices is illustrated in Figures 5a and 5b (from now on, the elements corresponding to the ones of the preceding figures will be differentiated by means of a prime notation). Particularly, the figures show a generic electronic device 105' of the Quad Flat Package (QFP) type. In this case, the electronic device 105' has a case 205' with terminals 210' that extend from each one of its four sides; the terminals 210' are of the Gull Wing type (i.e., they consist of leads extending horizontally, which are bent downwards and then outwards so as to define a flat contact for the surface mounting of the electronic device 105').

The burn-in board 125' is again formed by a circuitized insulating substrate 215' with a matrix of conductive pads 220'. A conductive seat 225' is formed on top of each pad 220' for receiving the corresponding terminal 210'. In this case, each seat 225' includes a print that matches the flat contact of the terminal 210'. Preferably, four centering towers 505 are further formed on the top surface of the substrate 215'. The centering towers 505 are higher than the seats 225', so as to reach the case 205' (when its terminals 210' rest on the seats 225'). The centering towers 505 are arranged at the four corners of the case 205'; each centering tower 505 has an internal depression for receiving the corresponding corner of the case 205'. The centering towers 505 facilitate the positioning of the electronic device 105' on the burn-in board 125' and prevent any misalignment between them (even in this case wherein the terminals 210' are not self-centering).

As above, when the chamber 235 expands the box 230 acts on a back surface of the case 205', so as to push the terminals 210' against the corresponding seats 225' (at the same time warming or cooling the electronic device 105'); moreover, the case 205' interferes with the centering towers 505, which maintain the electronic device 105' in the desired position. Conversely, when the chamber 235 reduces the electronic device 105' is released.

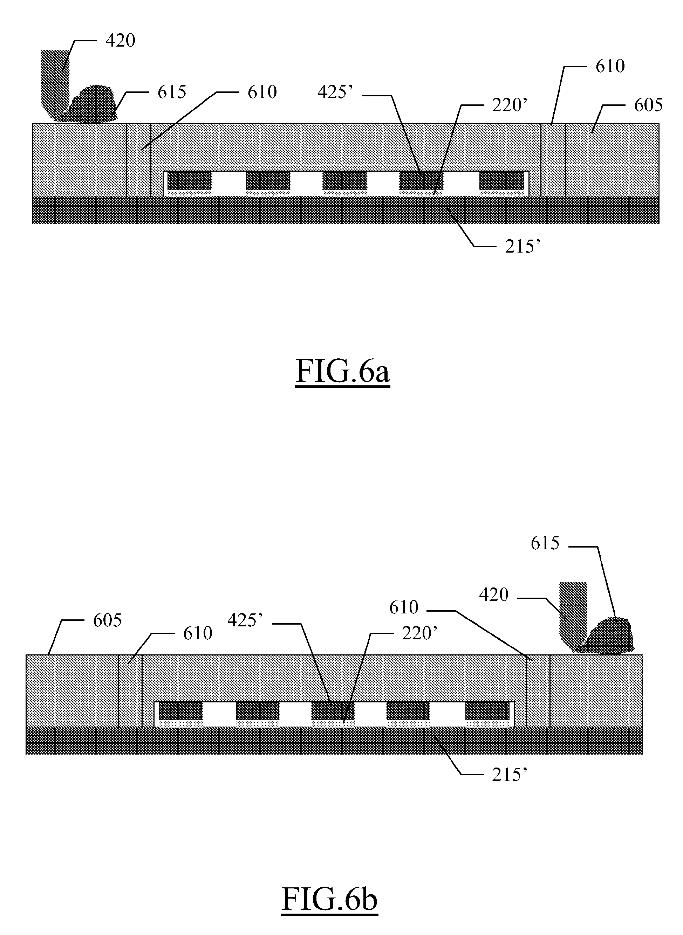

The various stages of a process that may be used to manufacture the above-described burn-in board are illustrated in Figures 6a-6e.

Considering in particular Figure 6a, the same operations described above are repeated to form the pads 220' on the top surface of the substrate 215'; likewise, corresponding isles 425' (of the same electrical conductive and deformable material) are created on the pads 220' by means of a silk-screen printing operation. A further silk-screen printing operation is now carried out to distribute a precursor material required to create the centering towers on the substrate 215'. For this purpose, a stencil 605 is placed on the substrate 215'. The stencil 605 is thicker that the one used to create the isles 425', and it is provided with foots for spacing it from the isles 425' (so as to avoid damaging them); the stencil 605 includes four windows 610 at the corners of the matrix of pads 220' (only two shown in the figure). A polymer 615 is then applied on the substrate 215' - through the stencil 605 - by means of the same knife 420; the polymer 615 consists of a deformable material (either conductive or insulating), such as the same being used to form the isles 415'.

As above, see Figure 6b, this result is achieved by making the knife 420 cross the whole stencil 605; in this way, the polymer 615 is pushed into the windows 610.

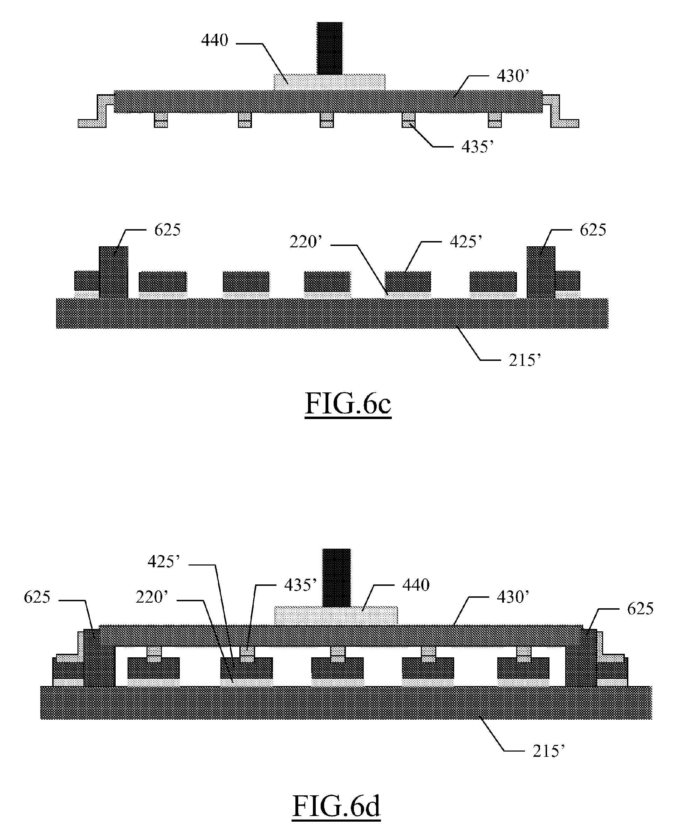

Moving to Figure 6c, when the stencil is removed four columns 625 of the polymer remains on the substrate 215'. The isles 425' and the columns 625 are then shaped - according to the electronic devices to be tested - by means of a forming tool 430'. The forming tool 430' has a main body corresponding to the case of the electronic devices; dummy elements 435' extend from each one of the four sides of the main body of the forming tool 430', so as to mimic the terminals of the electronic devices. The forming tool 430' is mounted on the same head 440 as above.

At this point, the head 440 is lowered so as to push the forming tool 430' against the substrate 215 (see Figure 6d). Therefore, the dummy elements 435' act as a die that presses the isles 425' accordingly (shaping them as a negative of the dummy elements 435', and then of the terminals of the electronic devices). At the same time, each corner of the main body of the forming tool 430' prints an internal portion of the corresponding column 625.

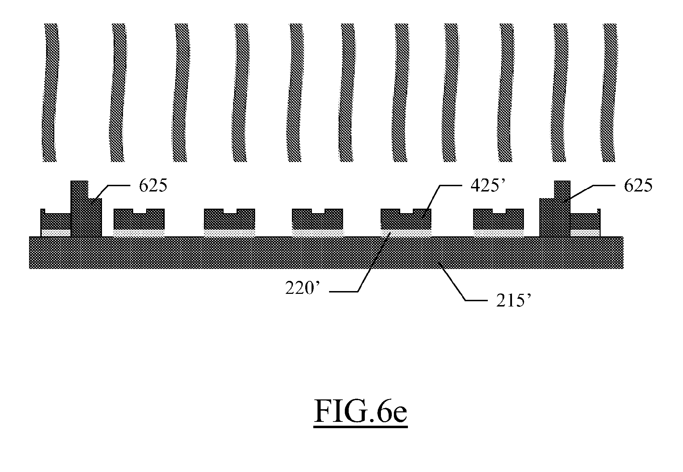

Moving to Figure 6e, the head is raised and the forming tool is removed. The structure so obtained is again passed in an oven, so as to polymerize the material forming the (shaped) isles 425' and columns 625. In this way, the isles 425' and the columns 625 harden to provide the desired seats and centering towers, respectively, for the electronic devices.

Naturally, in order to satisfy local and specific requirements, a person skilled in the art may apply to the solution described above many logical and/or physical modifications and alterations. More specifically, although the present invention has been described with a certain degree of particularity with reference to preferred embodiment(s) thereof, it should be understood that various omissions, substitutions and changes in the form and details as well as other embodiments are possible. Particularly, the proposed solution may even be practiced without the specific details (such as the numerical examples) set forth in the preceding description to provide a more thorough understanding thereof; conversely, well-known features may have been omitted or simplified in order not to obscure the description with unnecessary particulars. Moreover, it is expressly intended that specific elements and/or method steps described in connection with any disclosed embodiment of the invention may be incorporated in any other embodiment as a matter of general design choice.

For example, similar considerations apply if the test equipment has a different structure or includes equivalent components. More generally, the test equipment may be used to carry out whatever test process, which requires conditioning the electronic devices thermally in the broadest acceptation of the term. For example, in addition to the above-mentioned burn-in test, the concepts of the present invention may also be applied to a reliability test during a preliminary development stage of the electronic devices. In this case, it is possible to test small batches of the electronic devices (down to the ones housed on a single test board); the test may even be carried out at different temperatures, thanks to the capability of conditioning each test board individually. Another example is that of a functional test or a parametric test (which may even be performed concurrently with the burn-in test in the same test equipment). Moreover, as described above, the electronic devices may be tested under electrical and/or environmental stress conditions (for example, by forcing specific thermal cycles); alternatively, it is possible to maintain the temperature of the electronic devices under test simply at a predetermined value (for example, the room temperature).

In any case, the proposed solution lends itself to be applied to any type of electronic devices (for example, of the optical type, based on discrete components, and so on). Moreover, the electronic devices may be provided in different packages (for example, of the Dual-In-Line type), or they may have equivalent terminals (for example, of the J-type).

Even though in the preceding description great emphasis has been given to the preferred embodiment of the invention based on the box with the flexible membrane, this must not be interpreted in a limitative manner. Indeed, the use of different pressing means (for pushing the electronic devices towards generic contact means of the test equipment and at the same time warming/cooling them) is not excluded; for example, nothing prevents providing a mechanical hot press (for example, with a flat plate that is warmed by means of an electric coil).

Similar considerations apply if the box has a different shape and/or size; likewise, the conditioning fluid may be replaced with any other liquid or gas (such as air). In any case, the desired result may also be achieved with the conditioning fluid that controls the volume of the chamber in a different way; for example, the provision of a rigid plate (which slides according to the pressure in the chamber for acting on the electronic devices when it is in an extracted position) is contemplated.

Alternatively, it is possible to implement an equivalent hydraulic circuit (even with different components) for controlling the pressure and the temperature of the conditioning fluid. However, nothing prevents acting directly on a closed chamber filled in with the conditioning fluid.

Without departing from the principle of the invention, the membrane may have a different shape, size and/or thickness; likewise, any other elastic and thermally conductive material may be used (for example, rubber).

Although it is preferable to have the membrane held by the rigid body of the box within its edge, this is not strictly necessary (with this feature that may be omitted in a simplified implementation of the invention).

In any case, this result may be achieved with any other equivalent structures (for example, by means of a grille).

The proposed solution lends itself to be implemented even with equivalent means for contacting the terminals of the electronic devices electrically.

Particularly, the use of seats with different shapes (even flat) is not excluded.

Means equivalent to the centering towers (for example, a frame) may be used to align the terminals of each electronic device with the corresponding seats; moreover, nothing prevents applying the same solution to the embodiment of the invention based on the concave seats as well.

In any case, this feature is not strictly necessary and it may be omitted in simplified implementations of the invention.

Naturally, the burn-in board (or more generally, any test board without socket) may have a different structure, it may include equivalent elements, or it may house any number of electronic devices to be tested. In any case, it is emphasized that the test board is suitable to be manufactured and put on the market even as a stand-alone product (for use in the above-described test equipment).

Similar considerations apply if the proposed test board is manufactured with an equivalent process (by using similar steps, removing some steps being not essential, or adding further optional steps - even in a different order). For example, it is possible to use any other material being deformable and electrically conductive for forming the seats of the test board (such as another epoxy resin), the polymer may be formed and hardened in a different way (for example, by means of a hot-pressing step), and the like.

Alternatively, it is possible to obtain the isles on the pads with another technique (for example, by depositing a layer of polymer and then removing it selectively).

The same remarks apply to the operations required to obtain the centering towers.

Of course, the above-described procedure for performing the burn-in test (or more generally, any other test process requiring the thermal conditioning of the electronic devices under test) is merely illustrative, and it must not to be interpreted in a limitative manner.

## Claims

1. A test equipment (100) for testing a set of electronic devices (105,105') each one having a plurality of terminals (210,210'), the test equipment including:
contact means (125,125') for contacting the terminals of the electronic devices electrically,
locking means (130) for locking the electronic devices with the contact means mechanically, and
conditioning means (130) for conditioning the electronic devices thermally,
**characterized in that**
the locking means and the conditioning means include pressing means (130) for acting on the electronic devices, the pressing means being adapted to push the electronic devices towards the contact means and to warm or cool the electronic devices.

2. The test equipment (100) according to claim 1, wherein the pressing means (130) includes at least one box (230) defining a chamber (235) with a variable volume, the box acting on the electronic devices (105,105') when in an expanded condition, pressure control means (345) for forcing a conditioning fluid in the chamber with a controlled pressure, the volume of the chamber varying according to the pressure of the conditioning fluid, and temperature control means (350) for controlling a temperature of the conditioning fluid.

3. The test equipment (100) according to claim 2, wherein the pressure control means (345) includes a pump (345) for causing the conditioning fluid to circulate through a hydraulic circuit (340) including the chamber (235) and the temperature control means (350).

4. The test equipment (100) according to claim 2 or 3, wherein the box (230) includes a rigid body (305) and a flexible membrane (320) made of a thermally conductive material for acting on the electronic devices (105,105'), the membrane being adapted to deform according to the pressure of the conditioning fluid.

5. The test equipment (100) according to claim 4, wherein the membrane (320) is fastened to the rigid body (305) along a border thereof, the box (230) further including holding means (325) for holding the membrane integral with the rigid body in a plurality of internal points within the edge.

6. The test equipment (100) according to claim 5, wherein the rigid body (305) has a bottom surface (310) opposite the membrane, the holding means (325) including a plurality of pins (325) extending from the bottom surface to the membrane (320).

7. The test equipment (100) according to any claim from 1 to 6, wherein the contact means (125,125') includes at least one test board (125,125') having a substrate (215,215') and a plurality of seats (225,225') on the substrate each one for resting a corresponding terminal (210,210').

8. The test equipment (100) according to claim 7, wherein each terminal (210) ends with a convex contact region, each seat (225) including a concave recess matching the convex contact region of the terminal.

9. The test equipment (100) according to claim 7 or 8, wherein the at least one test board (125') further includes alignment means (505) for aligning the terminals (210') of each electronic device (105') with the corresponding seats (225').

10. The test equipment (100) according to claim 9, wherein the electronic device (105') includes a case (205') with a plurality of corners, the alignment means (505) including a plurality of centering towers (505) each one for interfering with a corresponding corner of the case.

11. A test board (125,125') for use in the test equipment (100) according to any claim from 7 to 10.

12. A process for manufacturing the test board (125,125') according to claim 11, the method including the steps of:
forming a plurality of isles (425,425') on the substrate (215,215'), the isles being made of an electrically conductive and deformable material (420),
pressing at least one forming tool (430,430') including a plurality of forming elements (435,435') corresponding to the terminals (210,210') onto the isles for deforming the isles according to the forming elements, and
hardening the isles to obtain the corresponding seats (225,225').

13. The process according to claim 12, wherein the step of forming the isles (425) includes:
providing a plurality of contact pads (225,225') on the substrate (215,215'), and
distributing the material (430) on the pads through a stencil (405).

14. The process according to claim 12 or 13, further including the steps of:
forming a plurality of columns (625) of a deformable further material (620) on the substrate (215'), the columns being pressed in an inner portion by each corner of a main body of the forming tool (430'), and
hardening the columns to obtain the corresponding centering towers (505).

15. The process according to claim 14, wherein the step of forming the columns (625) includes:
distributing the further material (630) on the substrate (215') through a further stencil (605).

16. A method for testing a set of electronic devices (105,105') each one having a plurality of terminals (210,210'), the method including the steps of:
locking the electronic devices mechanically with contact means (125,125') for contacting the terminals of the electronic devices electrically, and
conditioning the electronic devices thermally,
**characterized in that**
the steps of locking and conditioning include:
causing pressing means (130) to act on the electronic devices, the pressing means pushing the electronic devices towards the contact means and warming or cooling the electronic devices.
